# EUROPÄISCHE PATENTSCHRIFT

(11) **EP 2 404 325 B1**
(45) Veröffentlichungstag und Bekanntmachung des Hinweises auf die Patenterteilung: **03.12.2014**
(21) Anmeldenummer: 10706634.2
(22) Anmeldetag: 03.03.2010
(51) Int. Cl.: H01L 31/0236, H01L 31/18

(54) **VERFAHREN ZUR TEXTURIERUNG VON SILIZIUMWAFERN, BEHANDLUNGSFLÜSSIGKEIT DAFÜR UND VERWENDUNG**
METHOD FOR TEXTURING SILICON WAFERS, TREATMENT LIQUID THEREFOR, AND USE
PROCÉDÉ POUR TEXTURER DES PLAQUETTES DE SILICIUM, LIQUIDE DE TRAITEMENT CORRESPONDANT ET UTILISATION DUDIT LIQUIDE

(30) Priorität: 03.03.2009 DE 102009012827
(43) Veröffentlichungstag der Anmeldung: 11.01.2012
(73) Patentinhaber: Gebr. Schmid GmbH, 72250 Freudenstadt (DE)
(72) Erfinder: MAHER, Izaaryene, 52074 Aachen (DE)
(74) Vertreter: Patentanwälte Ruff, Wilhelm, Beier, Dauster & Partner
(86) Internationale Anmeldenummer: PCT/EP2010/052677
(87) Internationale Veröffentlichungsnummer: WO 2010/100185

(56) Entgegenhaltungen:
- EP-A2- 0 944 114
- EP-A2- 1 826 829
- DE-A1-102007 026 081
- JP-A- 2005 019 605
- ZUBEL I ET AL: "The effect of alcohol additives on etching characteristics in KOH solutions" SENSORS AND ACTUATORS A, ELSEVIER SEQUOIA S.A., LAUSANNE, CH, Bd. 101, Nr. 3, 30. Oktober 2002 (2002-10-30), Seiten 255-261, XP004386735 ISSN: 0924-4247
- YANG C R ET AL: "Effects of mechanical agitation and surfactant additive on silicon anisotropic etching in alkaline KOH solution" SENSORS AND ACTUATORS A, ELSEVIER SEQUOIA S.A., LAUSANNE, CH, Bd. 119, Nr. 1, 28. März 2005 (2005-03-28) , Seiten 263-270, XP025324968 ISSN: 0924-4247

## Beschreibung

### Anwendungsgebiet und Stand der Technik

Die Erfindung betrifft ein Verfahren zur Behandlung von Siliziumwafern für die Herstellung von Solarzellen gemäß dem Oberbegriff des Anspruchs 1 sowie eine dazu geeignete Behandlungsflüssigkeit. Des Weiteren betrifft die Erfindung die Verwendung einer erfindungsgemäßen Behandlungsflüssigkeit zur Durchführung des Verfahrens.

Es ist beispielsweise aus der DE 102007026081 A1 bekannt, Siliziumwafer für die Herstellung von Solarzellen zu texturieren. Dazu wird auf ihre Oberfläche eine Behandlungsflüssigkeit aufgebracht, wodurch auf der Siliziumoberfläche pyramidenartige Vorsprünge gebildet werden. Diese verbessern eine Lichteinkopplung in den Siliziumwafer und später in die Solarzelle und damit auch deren Energieausbeute. Die Behandlungsflüssigkeit kann Isopropanol als Ätzinhibitorzusatz aufweisen.

### Aufgabe und Lösung

Der Erfindung liegt die Aufgabe zugrunde, ein eingangs genanntes Verfahren sowie eine dazu geeignete Behandlungsflüssigkeit zu schaffen, mit denen Probleme des Standes der Technik vermieden werden können und insbesondere ein schnelleres und besseres Behandeln bzw. Texturieren möglich ist.

Gelöst wird diese Aufgabe durch ein Verfahren mit den Merkmalen des Anspruchs 1, eine Behandlungsflüssigkeit mit den Merkmalen des Anspruchs 5 sowie eine Verwendung mit den Merkmalen des Anspruchs 8. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Die Behandlungsflüssigkeit, die vorteilhaft eine alkalische Behandlungsflüssigkeit ist, weist ein Additiv auf. Dieses Additiv kann als Ätzinhibitorzusatz dienen und ist erfindungsgemäß ein Ethylhexanol oder Cyclohexanol. Die beiden Additive können vorteilhaft alternativ zueinander eingesetzt werden, unter Umständen aber beide zusammen. Der Vorteil dieser speziellen Additive in der Behandlungsflüssigkeit liegt darin, dass dann in weiterer Ausgestaltung der Erfindung aufgrund deren höheren Siedepunktes das Verfahren bei höherer Temperatur als sonst durchgeführt werden kann. Aufgrund der Siedepunkte von Ethylhexanol bei 182°C und von Cyclohexanol bei 161°C kann eben die damit versetzte Behandlungsflüssigkeit stärker erhitzt werden für das Texturierungsverfahren.

Aufgrund des niedrigen Siedepunkt des früher verwendeten Additivs Isopropanol mit 82°C musste dabei entweder ständig Isopropanol nachgefüllt werden, um kein verschlechtertes Texturierungsergebnis zu erhalten, oder die Temperatur musste bei 80°C oder sogar darunter gehalten werden. Dann wiederum ist die Verfahrensdauer für die Behandlung bzw. Texturierung erheblich länger, was ebenfalls als sehr nachteilig anzusehen ist. Mit den erfindungsgemäßen Additiven kann das Texturierungsverfahren also bei 80°C oder mehr durchgeführt werden, beispielsweise bei etwa 90°C. Dann kann eine Behandlungsdauer bei 10 bis 15 Minuten liegen, vorteilhaft bei etwa 11 Minuten. Anschließend werden die Siliziumwafer aus einem Bad mit der Behandlungsflüssigkeit entfernt und gespült sowie getrocknet und weiter verarbeitet.

In weiterer Ausgestaltung der Erfindung kann der Siliziumwafer in der Behandlungsflüssigkeit bewegt werden, was ebenfalls die Texturierung verbessert bzw. beschleunigt. Es kann hier auch vorgesehen sein, dass eine Relativbewegung zwischen Siliziumwafer und Behandlungsflüssigkeit stattfindet, also möglicherweise auch die Behandlungsflüssigkeit bewegt bzw. durchmischt wird oder eine innere Strömung aufweist.

Zur Erfindung gehört auch die Verwendung des erfindungsgemäßen Verfahrens, insbesondere zur Behandlung von Siliziumwafern für die Herstellung von Solarzellen.

Die erfindungsgemäße Behandlungsflüssigkeit kann neben dem Additiv in Form von Ethylhexanol oder Cyclohexanol noch Wasser aufweisen. Dabei kann ein Additiv in einer Menge zwischen 0,3 Gew.% und 4 Gew.% zugesetzt sein, besonders vorteilhaft zwischen 0,5 Gew.% und 3 Gew. %.

In nochmals weiterer Ausgestaltung der Erfindung kann die Behandlungsflüssigkeit zusätzlich auch noch KOH aufweisen. Eine Dosierung kann hier 1,5 Vol.% bis 5 Vol.% betragen, vorteilhaft 2 Vol.% bis 3 Vol.%.

Ein weiterer unabhängiger Aspekt der Erfindung ist die Verwendung einer erfindungsgemäßen Behandlungsflüssigkeit zur Durchführung eines Verfahrens, insbesondere zur Durchführung eines Verfahrens, wie es oben beschrieben ist.

Diese und weitere Merkmale gehen auch noch aus den Ansprüchen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird.

Bezüglich einer Durchführung des erfindungsgemäßen Verfahrens wird ebenso auf die DE 102007026081 A1 verwiesen, deren Inhalt diesbezüglich durch ausdrückliche Bezugnahme zum Inhalt der vorliegenden Beschreibung gemacht wird. Dort ist in den Figuren 1 und 2 dargestellt, wie ein Verfahren ablaufen kann und entsprechend kann es, mit den hier gegebenen Prozessparametern sowie Mengenangaben, genauso gemacht werden.

## Patentansprüche

1. Verfahren zur Behandlung von Siliziumwafern für die Herstellung von Solarzellen, wobei auf die Oberfläche der Siliziumwafer eine Behandlungsflüssigkeit aufgebracht wird zur Texturierung, wobei die Behandlungsflüssigkeit ein Additiv aufweist, **dadurch gekennzeichnet, dass** die Behandlungsflüssigkeit als Additiv Ethylhexanol oder Cyclohexanol aufweist.

2. Verfahren nach Anspruch 1, **dadurch gekennzeichnet, dass** das Verfahren bei einer Temperatur von 80° C bis 95° C, insbesondere etwa 90° C, durchgeführt wird.

3. Verfahren nach Anspruch 1 oder 2, **dadurch gekennzeichnet, dass** die Behandlungsflüssigkeit auf den Siliziumwafer für eine Dauer von 8 Minuten bis 20 Minuten aufgebracht wird, insbesondere für eine Dauer von 10 Minuten bis 13 Minuten.

4. Verfahren nach einem der vorhergehenden Ansprüche, **dadurch gekennzeichnet, dass** der Siliziumwafer in der Behandlungsflüssigkeit bewegt wird bzw. relativ zu dieser bewegt wird.

5. Behandlungsflüssigkeit zur Durchführung des Verfahrens nach einem der vorhergehenden Ansprüche, **dadurch gekennzeichnet, dass** sie neben Wasser noch Ethylhexanol oder Cyclohexanol als Additiv aufweist.

6. Behandlungsflüssigkeit nach Anspruch 5, **dadurch gekennzeichnet, dass** das Additiv in einer Menge zwischen 0,3 Gew.% und 4 Gew.% zugesetzt ist, vorzugsweise zwischen 0,5 Gew.% und 3 Gew.%.

7. Behandlungsflüssigkeit nach Anspruch 5 oder 6, **dadurch gekennzeichnet, dass** sie zusätzlich KOH aufweist, vorzugsweise in einer Menge von 1,5 Vol.% bis 5 Vol.%, insbesondere 2 Vol.% bis 3 Vol.%.

8. Verwendung einer Behandlungsflüssigkeit nach einem der Ansprüche 5 bis 7 zur Durchführung eines Verfahrens nach einem der Ansprüche 1 bis 4.

## Claims

1. A method for the treatment of silicon wafers for the production of solar cells, wherein a treatment liquid is applied to the surface of the silicon wafers for the purpose of texturization thereof, which treatment liquid contains an additive, **characterized in that** the treatment liquid contains ethylhexanol or cyclohexanol as additive.

2. The method according to claim 1, **characterized in that** said method is carried out at a temperature ranging from 80 °C to 95 °C, more particularly approximately 90 °C.

3. The method according to claim 1 or 2, **characterized in that** said treatment liquid is applied to the silicon wafer for a period ranging from 8 minutes to 20 minutes, more particularly for a period ranging from 10 minutes to 13 minutes.

4. The process according to any one of the preceding claims, **characterized in that** said silicon wafer is agitated in the treatment liquid or is moved relatively thereto.

5. A treatment liquid for carrying out the method according to any one of the preceding claims, -**characterized in that** it contains, in addition to water, ethylhexanol or cyclohexanol as additive.

6. The treatment liquid according to claim 5, **characterized in that** said additive is added in an amount ranging from 0.3 % to 4 %, by weight, and preferably from 0.5 % to 3 %, by weight.

7. The treatment liquid according to claim 5 or 6, **characterized in that** it additionally contains KOH, preferably in an amount of from 1.5 % to 5 %, by volume, and more particularly from 2 % to 3 %, by volume.

8. The use of a treatment liquid according to any one of claims 5 to 7 for carrying out the method according to any one of claims 1 to 4.

## Revendications

1. Procédé de traitement de plaquettes de silicium pour la fabrication de cellules solaires, selon lequel un liquide de traitement est appliqué sur la surface de la plaquette de silicium pour la texturation, le liquide de traitement comprenant un additif, **caractérisé en ce que** le liquide de traitement comprend de l'éthylhexanol ou du cyclohexanol en tant qu'additif.

2. Procédé selon la revendication 1, **caractérisé en ce que** le procédé est réalisé à une température de 80 °C à 95 °C, notamment d'environ 90 °C.

3. Procédé selon la revendication 1 ou 2, **caractérisé en ce que** le liquide de traitement est appliqué sur la plaquette de silicium pendant une durée de 8 minutes à 20 minutes, notamment pendant une durée de 10 minutes à 13 minutes.

4. Procédé selon l'une quelconque des revendications précédentes, **caractérisé en ce que** la plaquette de silicium est déplacée dans le liquide de traitement ou est déplacée par rapport à celui-ci.

5. Liquide de traitement pour la réalisation du procédé selon l'une quelconque des revendications précédentes, **caractérisé en ce qu'**il comprend en plus de l'eau également de l'éthylhexanol ou du cyclohexanol en tant qu'additif.

6. Liquide de traitement selon la revendication 5, **caractérisé en ce que** l'additif est ajouté en une quantité comprise entre 0,3 % en poids et 4 % en poids, de préférence entre 0,5 % en poids et 3 % en poids.

7. Liquide de traitement selon la revendication 5 ou 6, **caractérisé en ce qu'**il comprend en outre KOH, de préférence en une quantité de 1,5 % en volume à 5 % en volume, notamment de 2 % en volume à 3 % en volume.

8. Utilisation d'un liquide de traitement selon l'une quelconque des revendications 5 à 7 pour la réalisation d'un procédé selon l'une quelconque des revendications 1 à 4.
